# EUROPEAN PATENT APPLICATION

(11) **EP 4 614 576 A1**
(43) Date of publication of application: **10.09.2025**
(21) Application number: 24162340.4
(22) Date of filing: 08.03.2024
(51) Int. Cl.: H01L 29/778, H01L 29/417, H01L 29/06, H01L 29/20

(54) **A SEMICONDUCTOR STRUCTURE AND A METHOD TO PRODUCE A SEMICONDUCTOR STRUCTURE**

(71) Applicant: Epinovatech AB, 223 63 Lund (SE)
(72) Inventor: OLSSON, Martin Andreas, 223 63 Lund (SE)
(74) Representative: Zacco Sweden AB

(57) **Abstract**

A semiconductor structure comprising: a first substrate (101); a first layer (102) arranged on a frontside of the first substrate; a second layer (103), the second layer comprising GaN; a third layer (104), the third layer comprising a vertical conductive GaN structure (104a) laterally surrounded by resistive material (104b); a first heterojunction structure (105), the first heterojunction structure comprising a GaN layer and an AlGaN layer; a contact layer (109), the contact layer comprising a gate contact (110) aligned on a same vertical axis as the vertical conductive GaN structure of the third layer; the contact layer comprising a source/drain contact (111); a second substrate (113) bonded to the contact layer; a first via (114) extending from the backside of the first substrate to the gate contact in the contact layer; a second via (115) extending from the backside of the first substrate to the source/drain contact in the contact layer; a third via (116) extending from a backside of the first substrate to a source/drain contact in the second layer.

## Description

### Technical field

The present invention relates to a semiconductor structure and methods of producing such semiconductor structure.

### Background

Nitride semiconductors have larger bandgaps than silicon. Therefore, transistors made from nitride semiconductors have attracted attention. However, there are still improvements to be made to nitride semiconductor structures.

### Summary of the invention

An object of the present disclosure is to provide a semiconductor structure suitable for making a transistor for high power and/or high voltage and/or high-speed operation. In particular, an object is to provide a semiconductor structure suitable for making a vertical high-electron mobility transistor (HEMT) for high power and/or high voltage and/or high-speed operation. It is a further objective of the present inventive concept to provide a semiconductor structure which is robust and/or resilient to heat damage with current scaling. It is a further objective of the present inventive concept to provide a semiconductor structure for pinched-off current transport.

According to a first aspect there is provided a semiconductor structure. The semiconductor structure comprising: a first substrate; a first layer arranged on a frontside of the first substrate, the first layer comprising at least one AlN layer; a second layer arranged on the first layer, the second layer comprising Al(x)Ga(1-x)N, wherein 0 ≤ x ≤ 1; a third layer arranged on the second layer, the third layer comprising a vertical conductive GaN structure laterally surrounded by resistive material; a first heterojunction structure on the third layer, the first heterojunction comprising a GaN layer and an AlGaN layer; and a contact layer on the first heterojunction structure. The contact layer comprising a gate contact aligned on a same vertical axis as the vertical conductive GaN structure of the third layer. The contact layer comprising a source/drain contact to the first heterojunction structure. The semiconductor structure comprising a second substrate bonded to the contact layer; a first via extending from the backside of the first substrate to the gate contact in the contact layer; a second via extending from the backside of the first substrate to the source/drain contact in the contact layer; and a third via extending from a backside of the first substrate to a source/drain contact in the contact layer.

The semiconductor structure may be a vertical semiconductor structure. The semiconductor structure may be a vertical HEMT.

When in operation, current may flow from the source/drain contact of the contact layer along the first heterojunction structure and then vertically along the vertical conductive GaN structure to the source/drain contact in the second layer. Alternatively, the current may flow in the opposite direction. Current flow through the vertical conductive GaN structure may be gated by the gate contact.

It should be understood that the heterojunctions described herein may be configured to form a two-dimensional electron gas (2DEG). Alternatively, the heterojunctions described herein may be configured to form a two-dimensional hole gas (2DHG).

It is a realization that nitride semiconductor layers, such as the AIN of the first layer and the AI(x)Ga(1-x)N, wherein 0 ≤ x ≤ 1, of the second layer, grown on a substrate, e.g. a non-nitride substrate, may be fragile. Thus, such nitride semiconductor layers may break when released from the substrate and transferred to a carrier substrate. Therefore, it may be advantageous to avoid release from the substrate on which the nitride semiconductor layers have been grown. In this context, the first substrate may be a non-nitride substrate, e.g. a silicon substrate. The first substrate may be the substrate on which the first layer, the second layer, the third layer and the first heterojunction structure have been grown. The second substrate may be a carrier substrate. Thus, the nitride semiconductor layers may be sandwiched between the first and second substrates. The nitride semiconductor layers may thereby be protected and/or supported by the first and second substrates. Similarly, having the nitride semiconductor layers sandwiched between the first and second substrates may prevent the nitride semiconductor layers from breaking during operation. During operation of the transistor the layers may heat up, especially during high power and/or high voltage and/or high-speed operation. As layers of different materials may have different heat expansion coefficients they may expand differently which may cause the structure to break. The nitride semiconductor layers may be protected from such breakage by the first and second substrates.

Further, it is a realization that using vias through the first substrate to both source/drain contacts and to the gate contact may facilitate heat dissipation from the first heterojunction structure and from the vertical conductive GaN structure. For example, the second substrate may be configured for heat dissipation, e.g. without a need to consider electrical connections through the second substrate. As will be discussed below, the second substrate may e.g. comprise a heat sink.

For high power and/or voltage and/or high-speed operation, it is important that the resistive material laterally surrounding the vertical conductive GaN structure is of high quality, to block the current from taking the shortest path from drain to source when the device is pinched-off. It is a realization that by growing the resistive material laterally surrounding the vertical conductive GaN structure epitaxially, a high quality may be achieved. For example, the interface between the vertical conductive GaN structure and the resistive material may be of high quality, e.g. with few interface states. Further, by growing the resistive material epitaxially, the third layer may be crystalline. This may facilitate the formation of heterojunction structures (e.g. the first and/or second heterojunction structure described later). A 2DEG formed at a heterojunction may be very sensitive to crystalline imperfections (e.g. dislocations or surface roughness) propagating from below. For this reason, it is advantageous that layers below, such as the third layer are grown epitaxially. It should be understood that the conductive GaN layer and the second layer may also be epitaxially grown.

For high power and/or voltage and/or high-speed operation, it is important to avoid that a high electrical field arises in certain regions of the vertical HEMT. A uniform and/or low electric field distribution is advantageous. It is a realization that the configuration of the vertical conductive GaN structure is important to achieve uniform and/or low electric field distribution.

Gallium nitride, GaN-based semiconductors, i.e. compounds comprising (but not exclusively containing) gallium and nitrogen, provide numerous advantages compared to silicon. Electronic devices based thereon such as semiconductor structures, HEMTs and vertical HEMTs provide a promising candidate for replacing many silicon-based devices.

GaN-based semiconductor structures, such as HEMTs may offer faster switching speeds, increased electron mobility, lower resistances, larger breakdown voltages, etc. Compared to silicon-based transistors, a GaN-based device may offer low on-state resistances, and low switching losses when used as power switching transistors for voltage converter applications.

Further, GaN may exhibit ballistic transport at room temperature, especially if the GaN is in the form of a one-dimensional structure such as e.g. a nanowire. Thus, the vertical conductive GaN structure may be a nanowire, e.g. a tapered nanowire. The ballistic transport may be attributed to GaN having a high optical phonon energy. The optical phonon energy of GaN may be around 4 times higher than the optical phonon energy of other III-V semiconductors. The ballistic transport and/or the high optical phonon energy from a plurality of conductive apertures may lead to a high electron mobility and a lower ON-resistance, Rds(on), which may be advantageous for power chips.

The vias may be part of an interconnect between two transistors, e.g. between the first transistor and a second transistor of the semiconductor device.

Thanks to the vias entering the semiconductor device from the backside of the substrate, a semiconductor device comprising a first transistor may be more compact compared to a blind via entering from the frontside of the device.

The first substrate may not necessarily have the same thickness as during the growth. The first substrate may be thinned down, e.g. after bonding the contact layer to the second substrate.

The first substrate may comprise silicon. The substrate may comprise silicon with the crystallographic direction <111>, ceramic, or silicon carbide 4H-SiC. Silicon substrates are cheap and commercially readily available in small diameters of 50 mm to industrial large wafer sizes up to 300 mm diameter.

The first layer is arranged on the frontside of the first substrate.

The first layer comprises at least one AIN layer. The first layer may be a primer layer.

The second layer is arranged on the first layer. The second layer may comprise GaN or at least comprise a GaN sub-layer. The second layer may comprise at least two sub-layers of AlₓGa₁₋ₓN, wherein x≥0 and wherein the two layers of AlₓGa₁₋ₓN have different Aluminum-content. When comprising more than one layer, the second layer may be referred to as a stack of sub-layers. The second layer may be a superlattice. The first layer and the second layer may together form a so-called buffer layer. The second layer may further comprise strain layer management layers.

The second layer may comprise a plurality of layers alternating between having low and high Aluminum-content. Then, each layer of the second layer may have a composition of AlₓGa₁₋ₓN, wherein x≥0. The second layer may comprise at least 3 layers, at least 4 layers or at least 5 layers. The second layer may e.g. comprise alternating GaN and AIN layers.

The third layer is arranged on the second layer. The third layer comprises a vertical conductive GaN structure laterally surrounded by resistive material. In this context, resistive material may be interpreted as a material configured to form a barrier against current passing through the vertical conductive GaN structure, thereby blocking current from deviating from the vertical conductive GaN structure. Thus, the resistive material may alternatively be called barrier material or current blocking material. The resistive material and the vertical conductive GaN structure may comprise the same compound but with opposite doping. Alternatively, the resistive material may have a larger bandgap than the vertical conductive GaN structure.

The resistive material may comprise gallium. The resistive material may comprise carbon-doped GaN, p-doped GaN, iron-doped GaN. A doping concentration may be at least 1*10^¹⁸ cm⁻³, e.g. at least 5*10^¹⁸ cm⁻³. Thus, the doping concentration of p-doped GaN may be 1*10^²⁰ cm⁻³. The doping concentration of carbon-doped GaN may be 5*10^¹⁸ cm⁻³. The doping concentration of iron-doped, such as Fe-doped, GaN may be 10^¹⁹ cm⁻³. Fe-doping may be performed by ferrocene precursor. The resistive material may have a thickness of less than 500 nm. The resistive material may be a current blocking layer.

The vertical conductive GaN structure may be n-doped. The vertical conductive GaN structure may be elongated in a direction parallel to a plane of the substrate. In other words, the vertical conductive GaN structure may extend from the substrate in a direction parallel to the plane of the substrate. The vertical conductive GaN structure may form an electron transport channel.

The first heterojunction structure is arranged on the third layer. The first heterojunction comprising a GaN layer and an AlGaN layer. The term heterojunction structure should be understood as a structure comprising a junction between two different semiconductor materials. The first heterojunction structure forms an electron transport channel between the vertical conductive GaN structure and the source/drain contact to the first heterojunction structure. The AlGaN may be silicon doped. The AlGaN layer may have a thickness of 10-35 nm.

The contact layer is arranged on the first heterojunction structure. The contact layer comprises a gate contact aligned on a same vertical axis as the vertical conductive GaN structure of the third layer. The contact layer further comprises a source/drain contact to the first heterojunction structure.

The gate contact, the source contact, and the drain contact may comprise or substantially consist of metal material. Examples of metal materials available for use, by themselves or in an alloy/compound, may include Cu, Al, Pd, Au, Ag, Ni, Ti, W, TiW or TiN.

As mentioned, the second substrate is bonded to the contact layer. The second substrate may be a so-called carrier substrate.

The first via is extending from the backside of the first substrate to the gate contact in the contact layer. The first via connects from the backside of the substrate gate contact. Thus, the first via may be an electrical connection to the gate contact.

The second via is extending from the backside of the first substrate to the source/drain contact in the contact layer. The second via connects from the backside of the substrate source/drain contact. Thus, the second via may be an electrical connection to the source/drain contact.

The third via is extending from the backside of the first substrate to a source/drain contact in the contact layer. The third via connects from the backside of the substrate source/drain contact. Thus, the third via may be an electrical connection to the source/drain contact.

Thanks to the fact that the first, second and third via is extending from the backside of the first substrate, it is possible to have the second substrate still attached to the semiconductor device without releasing the devices from the first substrate and/or second substrate. Thus, the structure is more robust than if the second substrate was removed to give room for the vias from the side of the second substrate.

The AIN layer of the first layer may have a thickness in a range of 1-10 micron. This may facilitate growth of nitride layers on a non-nitride substrate.

The second substrate may comprise a heat sink.

It is an advantage of the present invention that the vias are extending from the backside of the first substrate, such that the second substrate can be used for both stabilizing the semiconductor structure and act as a heat sink. Thus, heat may be transported away through the second substrate.

Thus, the second substrate may comprise a heat conductive material.

The thickness of the third layer may be less than 500 nm. This may facilitate efficient gating of the vertical conductive GaN structure.

The second layer may have a crystal structure aligned with a crystal structure of the AIN layer of the first layer.

The second layer may be grown epitaxially on the first layer, e.g. on the AIN layer of the first layer. Thus, there may be an epitaxial relationship between the AIN layer of the first layer and the second layer (e.g. with a stack of layers of the second layer). In other words, the crystal structure of the second layer may be aligned with the crystal structure of the AIN layer.

The semiconductor structure may further comprise a p-doped GaN layer arranged between the heterojunction structure and the gate contact of the contact layer. The p-doped GaN layer allows for a transistor, in the final device, to be normally-off.

The vertical conductive GaN structure may be elongated in a direction parallel to a plane of the third layer. The semiconductor structure may further comprise a p-doped GaN layer arranged between the heterojunction structure and the gate contact of the contact layer for depleting the 2-dimensional electron gas in the interface of the GaN layer and the AlGaN layer of the first heterojunction structure. In other words, the vertical conductive GaN structure may extend from the third layer in a direction parallel to the plane of the third layer. The vertical conductive GaN structure may have a height in a direction orthogonal to the plane of the third layer. The height may be less than 500 nm. The vertical conductive GaN structure may have a length in a first direction parallel to the third layer. The length may be at least 100 microns, e.g. at least 1000 microns. Alternatively, the conductive aperture may comprise elongated portions of 10- 50 microns with p-type GaN therebetween. The vertical conductive GaN structure may have a width in a second direction parallel to the third substrate. The width may be at least 1 micron, e.g. 5-8 microns. The above dimensions are particularly advantageous for high power and high voltage applications.

An elongated vertical conductive GaN structure advantageously spreads the electric field in the finished vertical HEMT device.

The vertical conductive GaN structure may have a width of 5-8 microns.

The vertical conductive GaN structure may have a length of at least 1000 microns.

The semiconductor structure may further comprise an insulator layer. The insulator layer extends along the backside of the first substrate and along side walls of the first and the second via.

The semiconductor structure may further comprise a first contact being in electrical contact with the first via and a second contact being in electrical contact with the second via, the first and second contact being arranged on the backside of the first substrate. Thus, the first contact may be in electrical contact with the gate contact of the contact layer, through the first via. The second contact may be in electrical contact with the source/drain contact of the contact layer through the second via.

The first substrate may have a thickness of less than 750 µm. A thickness less than of 750 microns may be advantageous e.g. from a manufacturing point of view. The substrate may be thinned down or fully removed, e.g. after formation of ohmic source/drain contacts and gate contact to the 2DEG. Thinning may be performed by flipping the semiconductor structure upside down and bonding the frontside to a carrier substrate. In this case the substrate on which the first layer is arranged may be called first substrate and the carrier substrate may be called second substrate. The first substrate may have a thickness (e.g. after thinning) of 500 nm to 4 microns. This may facilitate formation of vias through the first substrate.

The first substrate may have a bow less than 10 µm. A bow below 10 microns may be advantageous as it may provide a flat semiconductor structure. A semiconductor structure with a bow below 10 microns may facilitate accurate patterning.

Generally, all terms used in the claims are to be interpreted according to their ordinary meaning in the technical field, unless explicitly defined otherwise herein. All references to "a/an/the [element, device, component, means, step, etc]" are to be interpreted openly as referring to at least one instance of said element, device, component, means, step, etc., unless explicitly stated otherwise. The steps of any method disclosed herein do not have to be performed in the exact order disclosed, unless explicitly stated.

A further scope of applicability of the present invention will become apparent from the detailed description given below. However, it should be understood that the detailed description and specific examples, while indicating preferred embodiments of the invention, are given by way of illustration only, since various changes and modifications within the scope of the invention will become apparent to those skilled in the art from this detailed description.

Hence, it is to be understood that this invention is not limited to the particular component parts of the device described or acts of the methods described as such device and method may vary. It is also to be understood that the terminology used herein is for purpose of describing particular embodiments only, and is not intended to be limiting.

It must be noted that, as used in the specification and the appended claims, the articles "a," "an," "the," and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings does not exclude other elements or steps.

### Brief description of the drawings

The above and other aspects of the present invention will, in the following, be described in more detail with reference to appended figures. The figures should not be considered limiting; instead they should be considered for explaining and understanding purposes.

As illustrated in the figures, the sizes of layers and regions may be exaggerated for illustrative purposes and, thus, are provided to illustrate the general structures. Like reference numerals refer to like elements throughout.

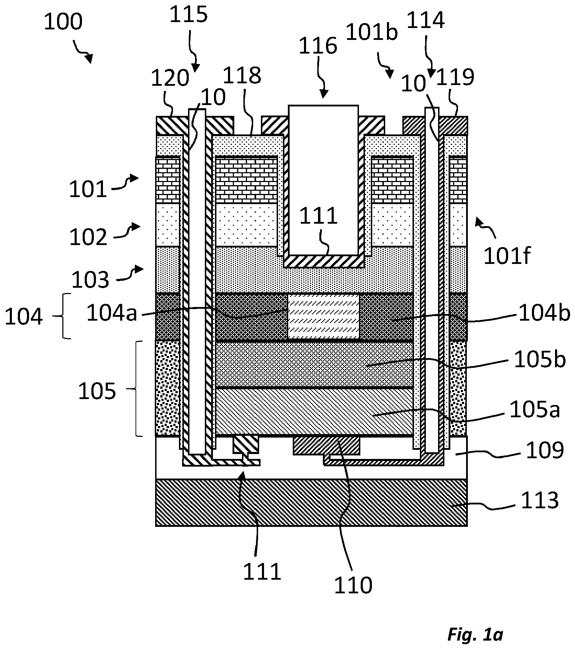

Fig. 1a shows a cross-sectional side view of a semiconductor structure.

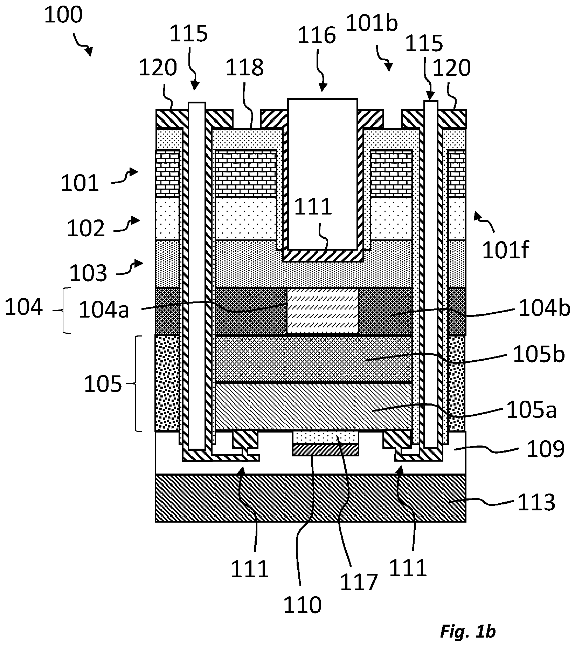

Fig. 1b shows a cross-sectional side view of a semiconductor structure.

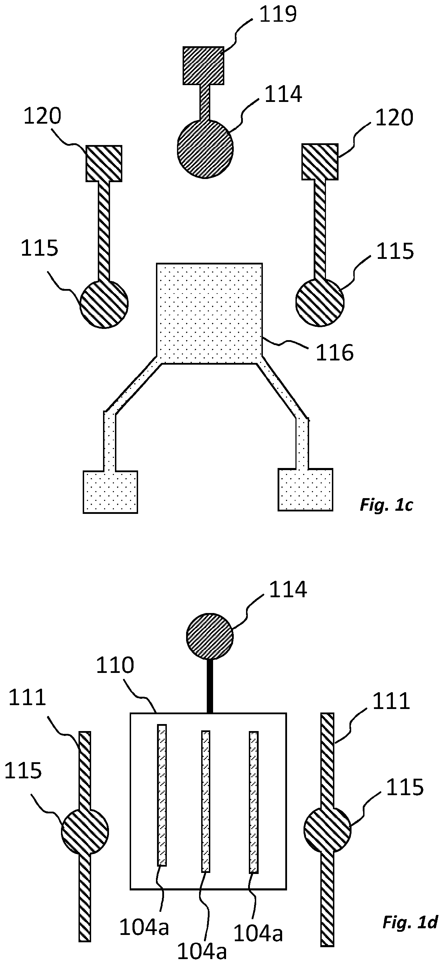

Fig. 1c shows a view of a semiconductor structure from the backside of the first substrate.
Fig. 1d shows a cross-sectional view of a semiconductor structure in the plane of the contact layer.

### Detailed description

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and to fully convey the scope of the invention to the skilled person.

Fig. 1a shows a cross-sectional side view of a semiconductor structure 100. The semiconductor structure 100 comprises a first substrate 101 having a frontside 101f and a backside 101b. A first layer 102 is arranged on the frontside 101f of the first substrate. A second layer 103 is arranged on the first layer 102. A third layer 104 is arranged on the second layer 103. A first heterojunction structure 105 is arranged on the third layer 104, A contact layer 109 is arranged on the heterojunction structure 105. In the illustration, the first substrate with the first 102 to third 104 layers, the heterojunction structure 105 and the contact layer 109 is flipped upside down (i.e. frontside 101f is facing down) and bonded to a second substrate 113. Thus, semiconductor structure 100 may be called a flip-chip.

The first substrate 101 may be a silicon, Si, substrate. The first substrate 101 may comprise silicone with the crystallographic direction <111>, ceramic, or silicon carbide 4H-SiC.

The first substrate 101 may have a thickness less than of 750 micron and the bow is below 10 microns.

The semiconductor structure 100 further comprises a first layer 102. The first layer 102 is arranged on the frontside 101f of the substrate 101. In other words, the first layer 102 is extending in the same plane as the substrate 101. The first layer 102 comprises at least one AIN sub-layer. The first layer 102 may be a sole AlN layer. The first layer 102 may be a primer layer. The AIN layer of the first layer 102 may have a thickness in a range of 1-10 microns.

The semiconductor structure 100 further comprises a second layer 103. The second layer is arranged on of the first layer 102. The second layer comprises AI(x)Ga(1-x)N, wherein 0 ≤ x ≤ 1. According to one example, the second layer may be a GaN layer. The second layer 103 may be a stack of sub-layers. The second layer 103 may comprise alternate AIN and GaN sub-layers. The second layer may 103 comprise at least two sub-layers of AlₓGa₁₋ₓN, wherein x≥0 and wherein the two layers of AlₓGa₁₋ₓN have different Aluminum-content. The second layer 103 may be a superlattice. The first layer 102 and the second layer 103 may together form a so-called buffer layer. The second layer 103 may further comprise strain layer management layers. The second layer 103 may comprise layers alternating between having low and high Aluminum-content. If the second layer 103 comprises several layers, each layer of the second layer 103 may have a composition of AlₓGa₁₋ₓN, wherein x≥0. The second layer 103 may comprise at least 3 layers, at least 4 layers or at least 5 layers.

The second layer 103 may have a crystal structure aligned with a crystal structure of the AIN layer of the first layer 102.

The semiconductor structure 100 further comprises a third layer 104. The third layer 104 is arranged on of the second layer 103. The third layer 104 comprises at least one vertical conductive GaN structure 104a. The at least one vertical conductive GaN structure 104a is laterally surrounded by resistive material 104b. The resistive material 104b may comprise gallium.

The resistive material 104b may comprise carbon-doped GaN, p-doped GaN, iron-doped GaN. A doping concentration may be at least 1*10^¹⁸ cm⁻³, e.g. at least 5*10^¹⁸ cm⁻³. Thus, the doping concentration of p-doped GaN may be 1*10^²⁰ cm⁻³. The doping concentration of carbon-doped GaN may be 5*10^¹⁸ cm⁻³. The doping concentration of iron-doped, such as Fe-doped, GaN may be 10^¹⁹ cm⁻³. The resistive material 104b may have a thickness of less than 500 nm. The resistive material 104b may be a current blocking layer. The conductive GaN layer 104a may be n-doped.

The vertical conductive GaN structure 104a may have a width of 5-8 microns. The vertical conductive GaN structure 104a may have a length of at least 1000 microns. In the figure, the width direction may be left to right and the length direction may be orthogonal to the plane of the figure. The vertical conductive GaN structure 104a may be elongated in a direction parallel to a plane of the third layer 104. In other words, the vertical conductive GaN structure 104a may extend from the third layer 104 in a direction parallel to the plane of the third layer 104. The vertical conductive GaN structure 104a may form an electron transport channel.

The thickness of the third layer may be less than 500 nm.

The semiconductor structure 100 further comprises a first heterojunction structure 105 on of the third layer 104. The first heterojunction structure 105 comprises an GaN layer 105a and an AlGaN layer 105b. The GaN layer 105a of the first heterojunction structure 105 faces the third layer 104. The GaN layer and AlGaN layer of the first heterojunction structure may be gallium-polar. The first heterojunction structure 105 may have a thickness of 20-30 nm. Thus, the combined thickness of a GaN layer and an AlGaN layer making up the heterojunction structure may be 20-30 nm.

The semiconductor structure 100 further comprises a contact layer 109 on the first heterojunction structure 105. The contact layer 109 comprises a gate contact 110 aligned on a same vertical axis as the vertical conductive GaN structure 104a of the third layer 104. In other words, a vertical axis passes through both the vertical conductive GaN structure 104a and the gate contact 110. The contact layer 109 comprises a source/drain contact 111 to the first heterojunction structure 105. The gate contact 110 and the source/drain contact 111 may comprise or substantially consist of metal material. Examples of metal materials available for use, by themselves or in an alloy/compound, may include Cu, Al, Pd, Au, Ag, Ni, Ti, W, TiW, or TiN. The source/drain contact 111 is arranged vertically offset from the vertical conductive GaN structure 104a. In other words, the source/drain contact 111 is not arranged on the same vertical axis as the vertical conductive GaN structure 104a.

The semiconductor structure 100 further comprises a second substrate 113 bonded to the contact layer 109. The second substrate 113 may comprise heat sink. The second substrate 113 may comprise a heat conductive material.

The semiconductor structure 100 further comprises a first via 114 extending from the backside 101b of the first substrate 101 to the gate 110 contact in the contact layer 109. The first via 114 may be a blind via extending into the heterojunction structure 105. The first via 114 may comprise a metal contact arranged in the first via 114.

The semiconductor structure 100 further comprises a second via 115 extending from the backside of the first substrate 101 to the source/drain contact 111 in the contact layer 109.

The semiconductor structure 100 further comprises a third via 116 extending from a backside of the first substrate 101 to a source/drain contact 111 in the second layer 103.

The first 114, second 115 and third 116 via provides an electrical contact to the gate 110, source and drain respectively. Herein, the source/drain contact 111 of the contact layer may act as source and the source/drain contact 111 in the second layer 103 may act as drain, or vice versa.

The illustrated semiconductor structure 100 further comprises an insulator layer 118. The insulator layer 118 extends along the backside 101b of the first substrate 101 and along side walls of the first 114 and the second via 115. Such an insulator layer 118 may beneficially reduce current leakage between e.g. the gate contact 110 and one or more of the source/drain contacts 111 and better insulate and passivate the semiconductor structure 100.

As illustrated, each via 114, 115, 116 may comprise metal 10 arranged in a vertical hole. For example, the metal 10 may be arranged on side walls of a vertical hole, e.g. on the insulator layer 118 on the side walls of the vertical hole. Alternatively, the metal 10 may fill the vertical hole.

The illustrated semiconductor structure 100 further comprises a first contact 119 being in electrical contact with the first via 114 and a second contact 120 being in electrical contact with the second via 115, the first 119 and second contact 120 being arranged on the backside of the first substrate 101. Thus, the first contact 119 may be in electrical contact with the gate 110, through the first via 114. The second contact 120 may be in electrical contact with the source/drain contact 111 of the contact layer 109 through the second via 115.

With reference to Fig. 1a, the semiconductor structure 100 operation may be described as the gate contact 110 receiving a voltage. The voltage may act as a gate voltage for the vertical conductive GaN structure 104a. In other words, the gate contact may turn electrical conduction through the vertical conductive GaN structure 104a on or off. When the transistor is in an on-state, current may flow from the source/drain contact(s) 111 of the contact layer, along a 2DEG at the heterojunction interface within the heterojunction structure, through the vertical conductive GaN structure 104a to the source/drain contact 111 in the second layer 103.

It should be understood that in Fig 1a the semiconductor device 100 may be manufactured such that the first layer 102 is provided on the frontside 101f of the first substrate 101. Further, the second layer 103 is provided on the first layer 102. The third layer 104 is provided on the second layer 103. The heterojunction structure 105 is provided on the third layer 104 and the contact layer 109 is provided on the heterojunction structure 105. The second substrate 113 is provided on the contact layer 109.

After manufacturing, the semiconductor device 100 may be turned such that the backside 101b of the first substrate 101 faces upwards.

Fig 1b shows a cross-sectional side view of a slightly altered version of the semiconductor structure 100, where the semiconductor structure 100 further comprises a p doped GaN layer 117 arranged between the heterojunction structure 105 and the gate contact 110 of the contact layer 109.

In Fig 1b, there are two source/drain contacts 111 in the contact layer 109, one on each side of the gate contact 110. Thus, current may flow along the heterojunction structure both from the left and from the right, towards the vertical conductive GaN structure 104a and then upwards through the vertical conductive GaN structure 104a to the source/drain contact 111 in the second layer 103. Each source/drain contact 111 in the contact layer 109 may have its own second via 115, as illustrated. Alternatively, both source/drain contacts 111 in the contact layer 109 may be connected to the same second via 115.

The p-doped GaN layer 117 allows for a transistor, in the final device, to be normally off.

The semiconductor structure 100 further comprises an insulator layer 118. The insulator layer 118 extends along the backside 101b of the first substrate 101 and along side walls of the second vias 115.

The semiconductor structure 100 further comprises two first contacts 120, one for each second via 115.

In Fig. 1b, the first via 114 is not illustrated. It should be understood that the first via 114 may be arranged in a different plane than the two second vias 115. This is illustrated in Fig. 1c-d.

Fig. 1c shows a view of a semiconductor structure from the backside 101b of the first substrate 101. Thus, the first 114, second 115 and third 116 vias extend orthogonal to the plane of the figure. The third via 116 stops in the second layer 103, as described above, while the first 114 and second 115 vias continue down to the contact layer 109.

Fig. 1d shows a cross-sectional view of the same semiconductor structure 100 as seen in Fig. 1c, now illustrated in the plane of the contact layer 109. In the illustration, the first via 114 is electrically connected to the gate contact 110. The gate contact 110 is arranged on the same vertical axis as the vertical conductive GaN structures 104a. For illustrative purposes the vertical conductive GaN structures 104a are drawn in Fig. 1d, although it should be understood that they do not lie in the plane of the contact layer 109. In Fig. 1d, the gate contact 110 overlaps the vertical conductive GaN structures 104a. In Fig. 1d, there are two source/drain contacts 111 in the contact layer 109, one on each side of the gate contact 110. Each source/drain contact 111 in the contact layer 109 of the figure has its own second via 115. In the illustration, each second via 115 is electrically connected to a source/drain contact 111 in the contact layer 109. Fig. 1d further illustrates that there may be a plurality of the vertical conductive GaN structures 104a. Fig. 1d further illustrates that a vertical conductive GaN structure 104a may be elongated. In one embodiment the frontside (FS) and backside (BS) gate, FS source and BS drain may be configured to provide stray inductance cancellation by opposing magnetic fields for high-frequency operation and parallelization of GaN devices.

Additionally, variations to the disclosed embodiments can be understood and effected by the skilled person in practicing the claimed invention, from a study of the drawings, the disclosure, and the appended claims.

## Claims

1. A semiconductor structure (100) comprising:
a first substrate (101);
a first layer (102) arranged on a frontside (101f) of the first substrate (101), the first layer (102) comprising at least one AlN layer;
a second layer (103) arranged on the first layer (102), the second layer (103) comprising Al(x)Ga(1-x)N, wherein 0 ≤ x ≤ 1;
a third layer (104) arranged on the second layer (103), the third layer (104) comprising a vertical conductive GaN structure (104a) laterally surrounded by resistive material (104b);
a first heterojunction structure (105) on the third layer (104), the first heterojunction structure (105) comprising a GaN layer (105a) and an AlGaN layer (105b);
a contact layer (109) on the first heterojunction structure (105), the contact layer (109) comprising a gate contact (110) aligned on a same vertical axis as the vertical conductive GaN structure (104a) of the third layer (104), the contact layer (109) comprising a source/drain contact (111) to the first heterojunction structure (104);
a second substrate (113) bonded to the contact layer (109);
a first via (114) extending from the backside of the first substrate (101) to the gate contact (110) in the contact layer (109);
a second via (115) extending from the backside of the first substrate (101) to the source/drain contact (111) in the contact layer (109);
a third via (116) extending from a backside of the first substrate (101) to a source/drain contact (111) in the second layer (103).

2. The semiconductor structure (100) according to claim 1, wherein the AIN layer of the first layer (102) has a thickness in a range of 100 - 500 nm.

3. The semiconductor structure (100) according to claim 1 or 2, wherein the second substrate (113) comprises a heat sink.

4. The semiconductor structure (100) according to any one of claims 1-3, wherein a thickness of the third layer (104) is less than 500 nm.

5. The semiconductor structure (100) according to any one of claims 1-4, wherein the second layer (103) has a crystal structure aligned with a crystal structure of the AIN layer of the first layer (102).

6. The semiconductor structure (100) according to any one of claims 1-5, further comprising a p-doped GaN layer (117) arranged between the heterojunction structure (105) and the gate contact (110) of the contact layer (109).

7. The semiconductor structure (100) according to any one of claims 1-6, wherein the vertical conductive GaN structure (104a) is elongated in a direction parallel to a plane of the third layer (104).

8. The semiconductor structure (100) according to claim 7, wherein the vertical conductive GaN structure (104a) has a width of 5-8 microns.

9. The semiconductor structure (100) according to claim 7 or 8, wherein the vertical conductive GaN structure (104a) has a length of at least 1000 microns.

10. The semiconductor structure (100) according to any one of claims 1-9, wherein the semiconductor structure (100) further comprises an insulator layer (118), wherein the insulator layer (118) extends along the backside of the first substrate (102) and along side walls of the first (114) and the second (115) via.

11. The semiconductor structure (100) according to any one of claims 1-10, wherein the semiconductor structure (100) further comprises a first contact (119) being in electrical contact with the first via (114) and a second contact (120) being in electrical contact with the second via (115), the first (119) and second (120) contacts being arranged on the backside of the first substrate (101).

12. The semiconductor structure (200) according to any one of claims 1-10, wherein the first substrate (101) has a thickness of less than 750 µm and a bow less than 10 µm.
